# EUROPEAN PATENT SPECIFICATION

(11) **EP 3 827 453 B1**
(45) Date of publication and mention of the grant of the patent: **04.01.2023**
(21) Application number: 19733747.0
(22) Date of filing: 25.06.2019
(51) Int. Cl.: H01H 9/56, G01R 31/327, H01H 47/00

(54) **METHOD AND CONTROL UNIT FOR SWITCHING ON OR OFF A RELAY**
VERFAHREN UND STEUEREINHEIT ZUM EIN- ODER AUSSCHALTEN EINES RELAIS
PROCÉDÉ ET UNITÉ DE COMMANDE POUR METTRE SOUS TENSION OU HORS TENSION UN RELAIS

(30) Priority: 24.07.2018 DE 102018212315
(43) Date of publication of application: 02.06.2021
(73) Proprietor: BSH Hausgeräte GmbH, 81739 München (DE)
(72) Inventor: CICÁK, Stanislav, 07101 Michalovce (SK); SPISÁK, Peter, 07101 Michalovce (SK)
(86) International application number: PCT/EP2019/066812
(87) International publication number: WO 2020/020555

(56) References cited:
- WO-A1-2017/055031
- DE-A1- 19 529 013
- FR-A1- 2 942 068
- US-A1- 2011 228 438
- US-A1- 2014 002 093

## Description

The present document is directed at a method and a control unit for controlling the state of an (electro-) mechanical relay, notably for setting the control time instant for switching on or off the relay.

Mechanical relays are widely used e.g. in home appliances. When switching a relay at a random time instant relatively to the AC mains power sine wave, the relay contacts and/or its mechanical components may be subjected to degradation resulting from plasmatic arcs which form between the relay contacts during switching events of the relay. The phenomenon of plasmatic arcs may cause degradation of the relay mechanics by damaging the relay contact material, by damaging the relay return springs and/or by damaging other relay mechanical parts. Furthermore, extensive electromagnetic emission noise may be caused by the arc current between the contacts, wherein the noise may disturb operation of an appliance. In addition, a plasmatic arc may cause contact material to be evaporated and/or scattered within a relay, thereby affecting the overall reliability of the relay. Eventually, a damaged relay may affect the reliability of the home appliance which comprises the relay.

In order to avoid the phenomenon of plasmatic arcs, zero cross detection for detecting the zero crossing of the AC mains voltage sine wave may be used. The switching times of a relay may then be set based on the detected zero crossing time instants, such that the relay is switched on or off at time instants when the AC mains voltage sine wave exhibits a zero crossing.

A relay typically exhibits a control delay between the control time instant of a control signal for switching on or off the relay and the (dis)connect time instant at which the relay is actually switched on or off, thereby allowing or disabling the AC mains current to flow. In order to perform the switch-on or switch-off of the relay at a zero crossing time instant, the control time instant needs to be advanced with regards to the zero crossing time instant by the control delay.

Document US2014002093 discloses a method according to the preamble of claim 1 and a device according to the preamble of claim 9.

The present document is directed at the technical problem of estimating the control delay of a relay in an efficient and precise manner, notably in order to reduce the degradation of a relay during operation of the relay in conjunction with an AC power supply. This technical problem is solved by the subject-matter of each of the independent claims. Preferred examples are described in the dependent claims, in the following description and in the attached drawing.

According to an aspect, a method for controlling a relay is described. The relay comprises a movable anchor or armature and a coil. The coil is configured to exert a (magnetic) force onto the anchor subject to a coil current (notably a DC (direct current) current) at a control port, in order to connect contacts of the relay. The contacts of the relay may be configured to enable or to disable an electrical connection between load ports of the relay. The load ports may be coupled to an AC voltage (e.g. a 230V mains voltage at an AC frequency of 50Hz or an 110V mains voltage at an AC frequency of 60Hz).

During a switch-on event, the contacts of the relay may be connected, i.e. brought into contact with one another, subject to a coil current creating a magnetic field which attracts the movable anchor. The coil current may be generated by applying a control voltage to the control port of the relay. On the other hand, during a switch-off event, the contacts may be disconnected, i.e. separated from one another, subject to the coil current dropping to zero, such that the magnetic field is interrupted. The coil current may be interrupted by coupling the control port to ground.

The method is described in claim 1 and comprises applying, at a control time instant, a control signal to the control port for initiating a switch-off event or a switch-on event of the relay. The control time instant depends on a previously determined control delay of the relay. The control signal may be a step-up function increasing the control voltage from zero to a constant control voltage level (for initiating a switch-on event). Alternatively, the control signal may be a step-down function decreasing the control voltage from the constant control voltage level to zero (for initiating a switch-off event).

In particular, the method comprises determining an upcoming or future zero crossing time instant of the AC voltage which is applied to the load ports of the relay. The zero crossing time instant may be the time instant at which the AC voltage changes polarity.

The control time instant is determined based on the previously determined control delay and based on the zero crossing time instant. In particular, the control time instant may be moved forward with respect to the (upcoming or future) zero crossing time instant by the control delay. By moving forward the control signal in dependence of the control delay of the relay, the disconnect time instant (at which the contacts of the relay disconnect) or the connect time instant (at which the contacts connect) may be moved closer to the zero crossing time instant (compared to an arbitrary selection of the control time instant). As a result of this, the generation of arcs between the contacts during a switch-off event or during a switch-on event may be reduced, thereby reducing degradation of the relay.

The method comprises determining a temporal course of the coil current subject to the control signal. As a result of the control signal for a switch-on event, the coil current may increase from substantially zero to a substantially constant on-current. The temporal course of the coil current until reaching the on-current may be determined. On the other hand, as a result of the control signal for a switch-off event, the coil current may decrease from the substantially constant on-current to substantially zero. The temporal course of the coil current until reaching substantially zero may be determined. The temporal course of the coil current may be sensed using a sensing or conversion resistor, which is configured to transform the coil current into a proportional coil voltage.

In addition, the method comprises detecting a disconnect time instant, at which the contacts of the relay disconnect, or a connect time instant, at which the contacts of the relay connect, based on a derivative of the temporal course of the coil current. The control signal may be for initiating a switch-off event. In this case, the disconnect time instant may be detected based on or using the first derivative of the temporal course of the coil current, notably based on a maximum of the first derivative of the temporal course of the coil current. On the other hand, the control signal may be for initiating a switch-on event. In this case, the connect time instant may be detected based on the second derivative of the temporal course of the coil current, notably based on a minimum of the second derivative of the temporal course of the coil current.

In addition, the method may comprise updating the control delay based on the detected disconnect time instant or based on the detected connect time instant. For updating the control delay, the time difference between the zero crossing time instant and the detected disconnect time instant or the detected connect time instant may be determined. The updated control delay may be increased or decreased based on the time difference (e.g. increased or decreased by a fraction of the time difference). The method may be repeated at subsequent cycles of the AC voltage, such that the determined control delay converges towards the actual control delay of the relay.

Using a derivative of the temporal course of the coil current during a switch-on or switch-off event, the actual disconnect time instants or connect time instants of a relay may be determined in a precise and reliable manner. By doing this, the generation of arcs during a switch-on or switch-off event may be reduced, thereby reducing degradation of a relay.

The method may comprise determining the control time instant as the zero crossing time instant minus the previously determined control delay and minus an offset. The offset may depend on a degree of reliability, notably a statistical scatter, of the control delay. By further offsetting the control time instant, the probability that an actual disconnect time instant or connect time instant occurs subsequent to the zero crossing time instant may be decreased (typically at the expense of increasing the probability that the actual disconnect time instant or connect time instant occurs prior to the zero crossing time instant). In view of the fact that, notably when switching off, an arc which is generated prior to the zero crossing time instant has a shorter duration than an arc which is generated subsequent to the zero crossing time instant, the use of an additional offset allows further reducing degradation of the relay (in particular, when making the offset dependent on the degree of reliability of the determined control delay).

The method may comprise detecting a peak of the first derivative of the temporal course of the coil current. The disconnect time instant may then be detected based on the peak, notably based on a time instant of a maximum of the peak, of the first derivative of the temporal course of the coil current. As a result of this, the disconnect time instant and by consequence the control delay may be determined in a particularly precise manner.

The method may comprise comparing the first derivative of the temporal course of the coil current with a peak detection threshold, in order to determine a (rectangular) envelope of the peak of the first derivative of the temporal course of the coil current. The disconnect time instant may then be determined in an efficient manner based on the envelope, notably based on a time instant of the center of the envelope. By determining the envelope of the peak, a binary signal may be generated, which allows the disconnect time instant to be determined in a particularly efficient manner (e.g. using a microprocessor). The method may comprise determining a peak value of the peak of the first derivative of the temporal course of the coil current. Furthermore, the method may comprise determining information regarding the state of health of the relay, notably regarding the gap width of the gap between the contacts, based on the peak value. In particular, the information regarding the state of health of the relay may be determined based on experimental data which is indicative of the state of health of the relay, notably of the gap width, as a function of the peak value. Depending on the information regarding the state of health of the relay, it may be initiating that the relay is maintained or replaced. As a result of this, the reliability of an appliance comprising the relay may be increased.

According to a further aspect, a control unit for controlling a relay is described in claim 9. The control unit may comprise analog and/or digital circuitry. The control unit is configured to apply, at a control time instant, a control signal to the control port for initiating a switch-off event or a switch-on event of the relay, wherein the control time instant depends on a previously determined control delay of the relay. Furthermore, the control unit may be configured to determine a temporal course of the coil current subject to the control signal, and to detect a disconnect time instant, at which the contacts of the relay disconnect, or a connect time instant, at which the contacts of the relay connect, based on a derivative of the temporal course of the coil current. In addition, the control unit may be configured to update the control delay based on the detected disconnect time instant or based on the detected connect time instant.

The control unit may comprise a conversion or sensing resistor configured to convert the coil current into a coil voltage. Furthermore, the control unit may comprise derivation circuitry which is configured to determine a first output signal indicative of a derivative of the course of the coil voltage, based on the course of the coil voltage. In addition, the control unit may comprise a microprocessor configured to sense the first output signal or a signal derived therefrom. The microprocessor may be further configured to detect the disconnect time instant or the connect time instant based on the sensed first output signal or the signal derived therefrom, and to update the control delay. Hence, the control unit may be implemented in an efficient manner using analog and digital circuitry.

The control unit may be configured to control a plurality of relays. The derivation circuitry may comprise an input portion and an output portion (wherein the output portion provides the first output signal). The control unit may comprise a plurality of conversion resistors for the corresponding plurality of relays. Furthermore, the control unit may comprise a plurality of input portions for the corresponding plurality of relays, and a single output portion for the plurality of relays. Hence, the output portion of the derivation circuitry may be used jointly for a plurality of different relays.

The control unit may be configured to detect the disconnect time instant or the connect time instant of the plurality of relays at a corresponding plurality of sequential time intervals, notably at a corresponding plurality of half cycles of an AC voltage applied to load ports of the plurality of relays. Hence, a plurality of relays of an appliance may be controlled and/or supervised in an efficient manner.

The control unit may comprise a comparator which is configured to compare the first output signal with a peak detection threshold to determine a second output signal which is indicative of a rectangular envelope around a peak of the first output signal. The microprocessor may be configured to detect the disconnect time instant or the connect time instant based on the second output signal, thereby further increasing the efficiency of the control unit.

According to a further aspect not according to the invention, a method for determining information regarding a state of health of a relay is described. The relay comprises a movable anchor and a coil which is configured to exert a force onto the anchor subject to a coil current at a control port, in order to connect contacts of the relay. The method comprises applying a control signal to the control port for initiating a switch-off event or a switch-on event of the relay. Furthermore, the method comprises determining a temporal course of the coil current subject to the control signal. In addition, the method comprises detecting a peak of a derivative of the temporal course of the coil current. The method further comprises determining a peak value of the peak of the derivative of the temporal course of the coil current, and determining information regarding the state of health of the relay, notably regarding a gap width of a gap between the contacts of the relay, based on the peak value.

It should be noted that the methods and systems including its preferred embodiments as outlined in the present document may be used stand-alone or in combination with the other methods and systems disclosed in this document. In addition, the features outlined in the context of a system are also applicable to a corresponding method. Furthermore, all aspects of the methods and systems outlined in the present document may be arbitrarily combined. In particular, the features of the claims may be combined with one another in an arbitrary manner.

The invention is explained below in an exemplary manner with reference to the accompanying drawing, wherein
Fig. 1 shows an example electromechanical relay;
Fig. 2a shows the temporal course or curve of the coil current during a switch-on event;
Fig. 2b shows the temporal course or curve of the coil current during a switch-off event;
Fig. 3a illustrates the connect time instant of a relay;
Fig. 3b illustrates the disconnect time instant of a relay;
Fig. 4 shows an example circuit for determining the control delay of a relay;
Fig. 5 shows an example circuit for determining the control delay of a plurality of relays;
Fig. 6 shows an example functional relationship between the peak coil current and the contact gap width of a relay;
Fig. 7 illustrates an example offset to be used for determining the control time instant for initiating a switch-on event or a switch-off event of a relay;
Fig. 8a shows a flow chart of an example method for controlling a switch-on event or a switch-off event of a relay; and
Fig. 8b shows a flow chart of an example method for determining the state of health of a relay.

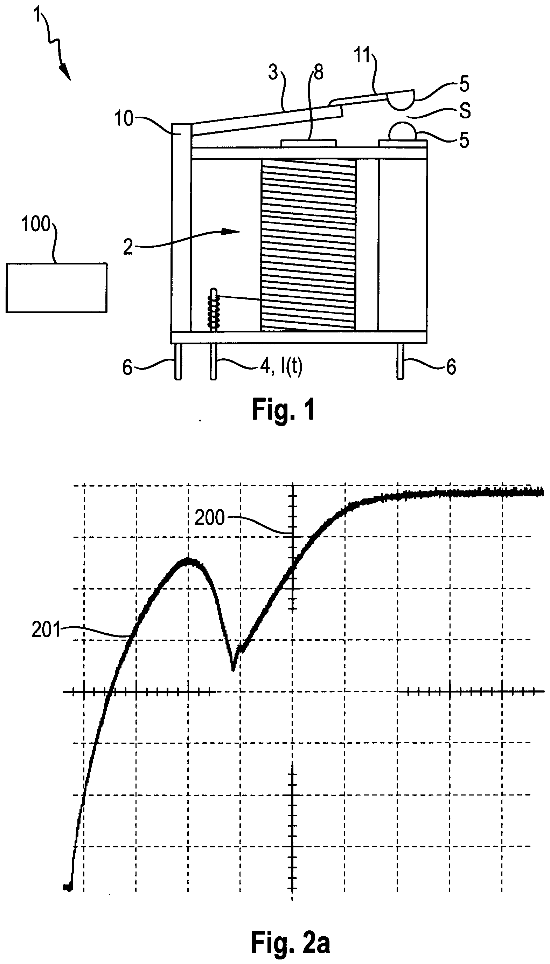

As indicated above, the present document is directed at reducing the degradation of an electromechanical relay, which is used for switching on or off an AC power supply (e.g. an AC mains supply at 230V with an AC frequency of 50Hz). In this context Fig. 1 shows an example relay 1. The relay 1 comprises a coil 2 which is configured to generate a magnetic field, subject to a coil current I(t) which is applied to the control port 4. The coil 2 may comprise a coil core 8, which is configured to direct the magnetic field towards an armature or anchor 3 of the relay 1. The armature or anchor 3 is configured to be attracted by the magnetic field generated by the coil 2. The armature 3 is typically moved away from the coil 2 and the coil core 8 using a spring 10. The magnetic field which is generated by the coil 2 may cause a sufficiently high attracting force onto the armature 3, such that spring force for the spring 10 is overcome and such that the armature 3 is pulled towards the coil core 8 to switch on the relay 1.

The armature 3 is coupled to a contact 5, wherein the contact 5 of the armature 3 touches the contact 5 of the base of the relay 1, when the armature 3 is pulled towards the coil core 8. As a result of this, the load ports 6 of the relay 1 are electrically coupled with one another, thereby allowing a current to flow between the load ports 6 and notably between the contacts 5.

By interrupting the coil current I(t), the magnetic field is interrupted and the armature 3 is pulled away from the coil core 8 due to the spring force caused by the spring 10. Eventually, the contacts 5 are disconnected from one another, thereby switching off the relay 1. In a relaxed or inactive state, the contacts 5 form a contact gap S having a certain gap width.

In the course of a switch-on event, the armature 3 is pulled towards the coil core 8, as soon as a coil current I(t) is applied to the control port 4. The coil current I(t) may be applied at a control time instant. At a subsequent connect time instant, the contacts 5 start touching each other, thereby switching on the relay 1 and thereby allowing a load current to flow via the load ports 6. At the connect time instant, the armature 3 typically does not yet touch the coil core 8. The time instant, at which the armature 3 touches the coil core 8 may be referred to at the close time instant, as the relay 1 is now fully closed. Once the relay 1 is fully closed, the (flexible) connecting plate between the armature 3 and the contact 5 of the armature 3 forms a flat spring 11 in a flexed condition, wherein the force of the flat spring 11 pulls the armature 3 away from the coil core 8. Hence, the magnetic field need to overcome the forces of the return spring 10 of the armature 3 and of the flat spring 11 of the contact 5.

In the course of a switch-off event, the control port 4 is disconnected from a control voltage (at a control time instant). As a result of this, the coil current I(t) decreases gradually such that the magnetic force decreases causing the flat spring 11 to return to a relaxed state and subsequently causing the return spring 10 to pull the contact 5 of the armature 3 away from the contact 5 of the base of the relay 1. The time instant, at which the contacts 5 are disconnected may be referred to as the disconnect time instant.

As outlined in the introductory section, a switch-on event or a switch-off event may lead to plasmatic arcs between the contacts 5, if the contacts 5 are connected or disconnected at a time instant, when the voltage across the load ports 6 is relatively high (e.g. 30V or higher). This may lead to a degradation of the contacts 5 and of the mechanical components of the relay 1. In order to avoid such degradations, it is preferable to place the (dis)connect time instant of a switch-on event or a switch-off event at a zero crossing of the AC voltage which is applied to the load ports 6. In view of this, the control delay between the control time instant, at which the control voltage is applied to or disconnected from the control port 4, and the (dis)connect time instant, at which the contact gap S is closed or opened, needs to be determined in a precise manner.

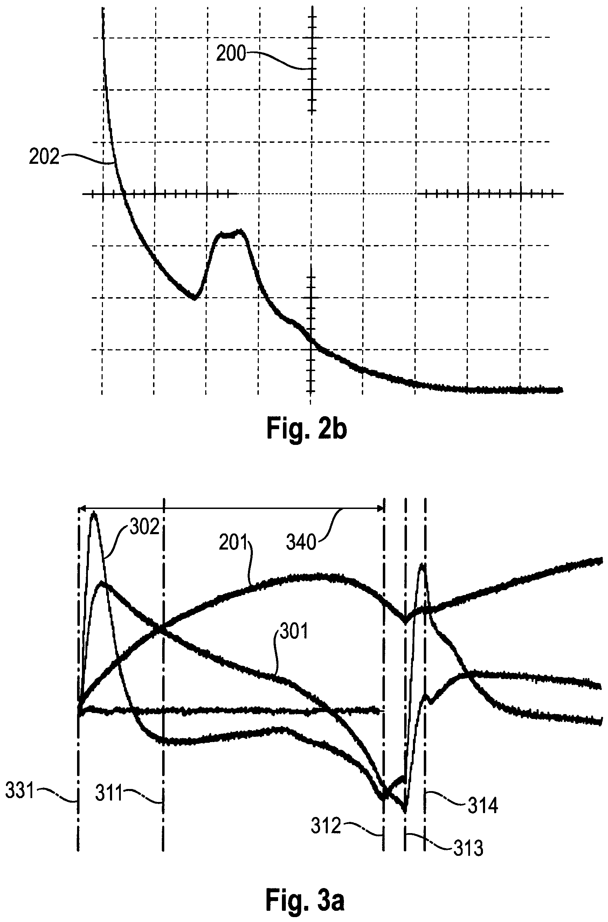

Fig. 2a shows an example curve or course 201 of the coil current 200 during a switch-on event. It can be seen that the coil current 200 increases gradually, but exhibits an intermediate drop. Fig. 2b shows an example curve or course 202 of the coil current 200 during a switch-off event. It can be seen that the coil current 200 decreases gradually, but exhibits an intermediate peak.

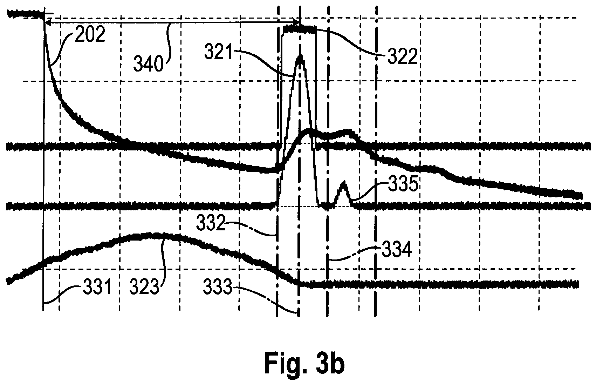

Figs. 3a and 3b show the example curves or courses 201, 202 of the coil current 200 during a switch-on event and a switch-off event, respectively. Furthermore, Figs. 3a and 3b illustrate different time instants for different incidents during a switch-on event and a switch-off event, respectively. In particular, Fig. 3a illustrates a time instant 311 at which the anchor or armature 3 starts to move. Furthermore, Fig. 3a shows the connect time instant 312 at which the contacts 5 of a relay 1 start touching each other. In addition, Fig. 3a shows a time instant 313 at which the anchor 3 and the coil core 8 start touching each other. Fig. 3a also shows a time instant 314 at which mechanical vibrations of the anchor 3 occur (subsequent to closing of the relay 1). The connect time instant 312 may e.g. be detected within a test environment by applying a (relatively small) DC test voltage to the load ports 6 and by detecting the time instant when the load ports 6 are short circuited.

Fig. 3a also shows the first derivative 301 of the coil current curve 201, as well as the second derivative 302 of the coil current curve 201. It can be seen from Fig. 3a that the minimum of the second derivative 302 of the coil current curve 201 during a switch-on event coincides with the connect time instant 312. Hence, the control delay 340 for a switch-on event may be determined in a precise manner by
- determining the second derivative 312 of the coil current curve 201 during a switch-on event; and
- determining the time instant of the minimum value of the second derivative 312 of the coil current curve 201.

Fig. 3b illustrates various different time instants of different incidents during a switch-off event of a relay 1. In particular, Fig. 3b shows the control time instant 331 at which the control voltage is disconnected from the control port 4 of the relay 1, in order to switch off the relay 1. Furthermore, Fig. 3b illustrates a time instant 332 at which the anchor release begins. In addition, Fig. 3b shows the disconnect time instant 333 at which the contacts 5 are effectively disconnected. Fig. 3b also shows the time instant 334 at which the anchor 3 reaches its relaxed position. In addition, Fig. 3b illustrates a bouncing incident 335 of the anchor 3 from the relaxed position.

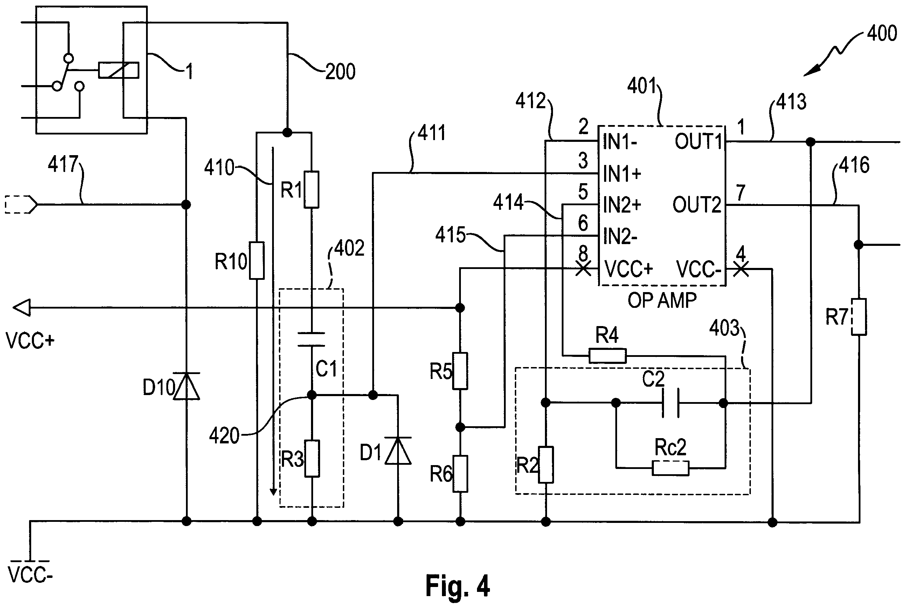

Fig. 3b also shows the positive part (i.e. the positive values) of the first derivative 321 of the curve 202 of the coil current 200 during a switch-off event (the negative part of the first derivative 321 has been omitted; notably the negative part of the first derivative 321 has been cut off by the operational amplifier 401 of the circuit 400 of Fig. 4, which is connected in a single supply mode). It can be seen that the maximum of the first derivative 321 coincides with the disconnect time instant 333. Hence, the control delay 340 of a switch-off event may be determined in a precise manner by
- determining the first derivative 321 of the curve 202 of the coil current 200 during a switch-off event; and
- determining the time instant of the maximum value of the first derivative 321 (being the disconnect time instant 333).

Determining a maximum or a minimum value may be difficult when using analog circuitry. In view of this, a comparator envelope 322 of the first derivative 321 of the curve 202 of the coil current 200 may be determined, using e.g. a comparator. The comparator envelope 332 exhibits a rectangular shape around the peak of the derivative 321. The disconnect time instant 333 may be determined in an efficient manner, by determining the duration of the rectangle of the comparator envelope 332 and by selecting the disconnect time instant 333 to be the time instant which cuts the duration of the rectangle of the comparator envelope 322 approximately in half.

As can be seen from Fig. 3b, the peak of the first derivative 321 may be (slightly) asymmetrical. As a result of this, the maximum value of the peak of the first derivative 321 may be (slightly) shifted with respect to the middle point of the comparator envelope 322. The asymmetry of the peak of the first derivative 321 and/or the required shift with respect to the middle point of the comparator envelope 322 for determining the disconnect time instant 333 may be determined experimentally prior to operation of a relay 1 and may be used subsequently during operation of the relay 1.

Fig. 4 shows an example (analog) circuit 400 for determining the disconnect time instant 333 and/or for determining the control delay 340. Fig. 4 shows the relay 1 which is controlled using the control signal 417. The coil current 200 through the coil 2 of the relay 1 may be converted into a corresponding coil voltage 410 using a sensing resistor R10. The coil voltage 410 may be differentiated using a differentiator or derivation circuit. The differentiator circuit comprises the C/R differentiator circuit 402 (comprising the capacitor C1 and the resistor R3). Hence, the first derivative 321 of the relay coil current vs. time (measured as a coil voltage 410 across R10) may be provided. The parts R1, C2, RC2 and R2 form a low pass filter 403 in conjunction with the operational amplifier 401 and provide for amplification of the filtered signals 411, 412. The output 413 of the operational amplifier 401 is indicative of the first derivative 321 of the coil current 200 (filtered and shaped by the operational amplifier 401).

The Schottky diode D1 (having a relatively low forward voltage) may be used to protect the input IN1+ of the operational amplifier 401 (when operated in single supply mode) against negative input voltages. The diode D10 has the function of a flyback diode.

The operational amplifier circuit 401 shown in Fig. 4 comprises two separate operational amplifiers. The second operational amplifier is used as a comparator for producing a rectangular envelope 322 of the differentiator signal 413. In particular, the output signal 413 of the first operational amplifier is fed back towards the input IN2+ of the second operational amplifier (as signal 414). Furthermore, a reference signal 415 (referred to herein as the peak voltage threshold) is derived from the DC supply voltage VCC of the circuit 400 using the voltage divider comprising the resistors R5, R6. The output 416 of the second operational amplifier indicates a rectangular envelope 322 around the peak of the first derivative 321 of the curve 202 of the coil current 200.

The output signal 413 of the first operational amplifier (indicative of the first derivative 321) and/or the output signal 416 of the second operational amplifier (indicative of the rectangular envelope 322 of the peak of the first derivative 321) may be provided to an input of a microprocessor (not shown) for further analysis. The microprocessor may be configured to determine the disconnect time instant 333 based on at least one of the output signals 413, 416 (e.g. by determining the time instant which cuts the rectangular envelope 322 in half). The control delay 340 may then be determined as the duration between the control time instant 331 and the disconnect time instant 333.

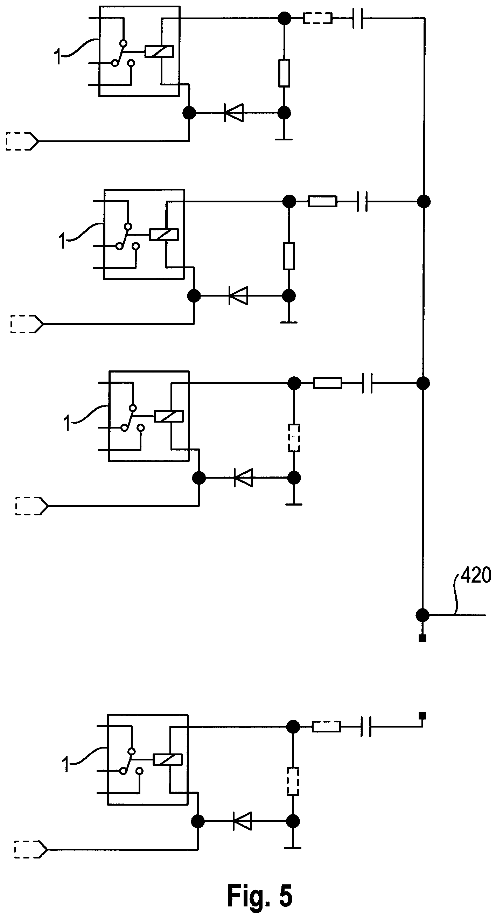

Fig. 5 shows an extension of the circuit 400 for determining the control delays 340 of a plurality of different relays 1. As can be seen from Fig. 5 that most of the circuitry of circuit 400 may be used in common for the plurality of relays 1. Only the sensing resistor R10 for deriving the coil voltage 410 from the coil current 200, the flyback diode D10, the resistor R1 (which is part of a low pass filter 403) and the capacitor C1 (which is part of the differentiator circuit 402) need to be provided for each relay 1 (and may be referred to as the input portion of the deviation circuit). The capacitors C1 for the different relays 1 may be coupled at node 420 to the jointly used components of the circuit 400 (which comprise a jointly used output portion of the deviation circuit).

Hence, the circuit 400 of Fig. 4 may be used in a multi-relay environment by (time) multiplexing of the derivative signals of the different relays 1 (without using any particular multiplexer). The self-multiplexing can be done by splitting the C1 R3 differentiator 402 and the low pass filter 403 as shown in Fig. 5. As can be seen in Fig. 5 each relay 1 has its dedicated flyback diode D10, its dedicated coil current measuring resistor R10, resistor R1 and derivative capacitor C1. The remaining portion of the differentiator and comparator circuits 401, 403 are common for all the relays 1. Such a self-multiplexing circuit provides an inexpensive and efficient way for providing an independent control of the switching-off time instants of multiple relays 1 with just one dedicated circuit 400 and relatively few passive parts added to each of the relays 1. The different relays 1 may exhibit different characteristics (e.g. with regards to electrical features and size of the relays 1).

The disconnect time instants 333 for the different relays 1 may be determined within different cycles or half cycles of the AC power supply, thereby performing a time multiplexed use of the joint portion of the circuit 400.

As indicated above, the output signals 413, 416 of circuit 400 each allow identifying the actual switch-off point (i.e. the disconnect time instant 333) of a relay 1, e.g. by finding the middle time of the analogue pulse (i.e. the rectangular envelope) 322. Furthermore, the output signals 413, 416 may each be used for predictive monitoring of the mechanical health of a relay 1, e.g. by monitoring the heights of the pulse or peak of the first derivative 321 (e.g. by monitoring the maximum value / voltage of the output signal 413 and/or by monitoring the pulse presence at the output signal 416). The maximum value of the first derivative 321 is related to the total accelerated mass of the mechanics and the flat spring deflection (i.e. the force) of the relay 1. In case of an obstacle between the relay contacts 305 (such as dirt, metal whiskers grown from the contact surface, etc.), which lowers the width of the contact working gap S, the peak voltage typically increases. On the other hand, if the width of the contact working gap S increases, e.g. by burning out or scattering of the contact material, the peak voltage may decrease.

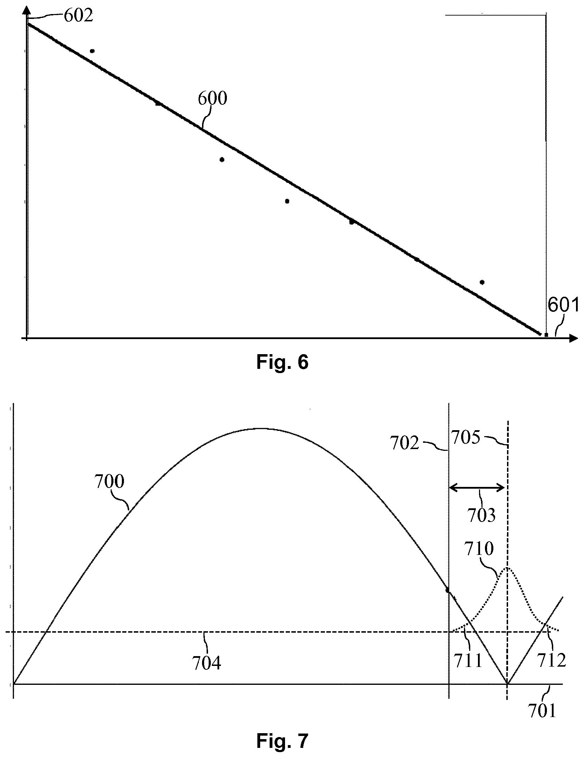

Fig. 6 shows data 600 indicating the functional relationship between the width 601 of the gap S and the peak value 602 of the first derivative 321. It can be seen that the peak value 602 has an almost linear relationship with the gap width 601. Hence, the gap width 601 may be determined in a reliable manner based on at least one of the output signals 413, 416 of the circuit 400. The determined gap width 601 may then be used for preventive maintenance, e.g. for indicating on a user interface of an appliance that a relay 1 should be replaced (e.g. because the contacts 5 of the relay 1 are deteriorated). By doing this, the reliability of an appliance may be increased.

The control of a relay 1 may be adapted in an iterative manner. A control unit 100 for controlling the relay 1 may be configured to store a value of the control delay 340 in a storage unit. Furthermore, the control unit 100 may be configured to determine the zero crossing time instant 705 of the AC power supply (see Fig. 7). If the relay 1 is to be switched on or off, then the control time instant 331 may be determined to be the zero crossing time instant 705 minus the stored control delay 340. As a result of this, the actual disconnection or connection of the contacts 305 of the relay 1 occurs at the zero crossing time instant 705, thereby avoiding the generation of arcs.

The control delay 340 may be determined repeatedly, using the scheme and/or the circuit 400 outlined in the present document. For this purpose, subsequent to a switch-on event or a switch-off event, the time difference between the actual connect time instant 312 or the actual disconnect time instant 333 and the zero crossing time instant 705 may be determined. The time difference may be used to increase or decrease the stored value of the control delay 340, thereby updating the control delay 340. The updated control delay 340 may then be stored in the storage unit of the control unit 100. By doing this, a precise control of a relay 1 may be maintained over the lifetime of the relay 1. Furthermore, the repeated determination of the first derivative 321 of the curve 202 of the coil current 200 during a switch-off event may be used for monitoring the state of health of the relay 1.

The creation of an arc during a switch-on or a switch-off event may be avoided if the voltage value of the AC supply voltage 700 at the connect time instant 312 or the disconnect time instant 333 is at or below a pre-determined voltage threshold 704 (as illustrated in Fig. 7). The pre-determined voltage threshold 704 typically depends on the environmental conditions (notably the humidity) of the relay 1. Typically, voltage thresholds 704 are around 30V (or 20V in case of high humidity) for a switch-off event.

As can be seen from Fig. 7, the AC supply voltage 700 is only below the voltage threshold 704 for a relatively small fraction (e.g. 6%) of the total time of a half cycle. In case of an AC frequency of 50Hz, the total time of a half cycle is 10ms and the time interval which is available for safely disconnecting the contacts 305 of the relay 1 may be as low as 400 to 600µs. Hence, the control delay 340 needs to be determined with relatively high precision and/or with a relatively high degree of reliability.

Fig. 7 shows an example statistical distribution 710 of the control delay 340 around the exact value of the control delay. The temporal width of the distribution is typically an indication of the degree of reliability. It can be seen from Fig. 7 that the control delay 340 which is determined using the schemes outlined in the present document, may deviate from the exact value of the control delay. If using the determined control delay 340 as an offset to the zero crossing time instant 705, it may occur that the resulting disconnect time instant 333 is prior or subsequent to the zero crossing time instant 705, such that the AC supply voltage 700 is higher than the voltage threshold 704 at the resulting disconnect time instant 333. This may lead to an arc between the contacts 5 of the relay 1.

If the actual value of the control delay is lower than the determined control delay 340, the resulting disconnect time instant 333 is prior to the zero crossing time instant 705, such that the AC supply voltage 700 is decreasing. By consequence, the arc between the contacts 5 is maintained only for a relatively short time interval. On the other hand, if the actual value of the control delay is higher than the determined control delay 340, the resulting disconnect time instant 333 is subsequent to the zero crossing time instant 705, such that the AC supply voltage 700 is increasing. By consequence, the arc between the contacts 5 is maintained for a relatively long time interval, until the following zero crossing time instant.

In the case which is illustrated in Fig. 7, the probability 711 that an arc is created on the decreasing slope of the AC supply voltage 700 (i.e. prior to the zero crossing time instant 705) is equal to the probability 712 that an arc is created on the increasing slope of the AC supply voltage 700 (i.e. subsequent to the zero crossing time instant 705). The impact of an arc on the deterioration of a relay 1 typically increases with increasing duration of the arc. Hence, it may be beneficial to increase the probability 711 in order to decrease the probability 712. This may be achieved by increasing the determined control delay 340 with an offset 703, such that the center of the distribution 710 shown in Fig. 7 is moved towards the decreasing slope of the AC supply voltage 700. The offset 703 may be determined such that the probability 712 is below a pre-determined probability threshold (close to zero). In particular, the offset 703 may be determined in dependence of the distribution 710 of the determined control delay 340. As illustrated in Fig. 7, applying an offset 703 to the control delay 340 corresponds to applying the offset 703 to the zero crossing time instant 705, thereby providing an offset zero crossing time instant 702. The determined control delay 340 may be subtracted from the offset zero crossing time instant 702 to determine the control time instant 331 for initiating a switch-off event.

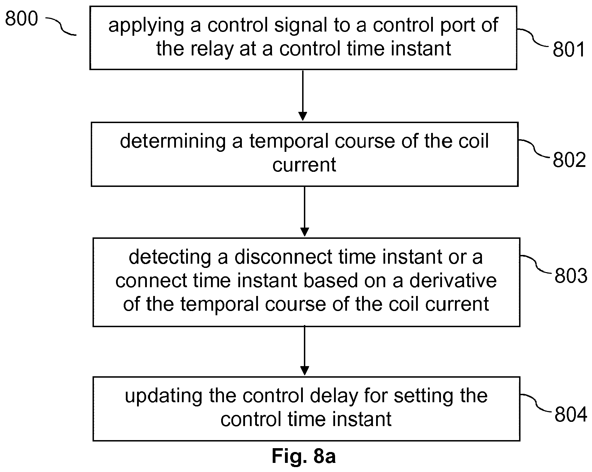

Fig. 8a shows a flow chart of an example method 800 for controlling a relay 1, wherein the relay 1 comprises a movable anchor or armature 3 and a coil 2. The coil 2 is configured to exert a (magnetic) force onto the anchor 3 subject to a coil current 200 at a control port 4 or the relay 1, in order to connect contacts 5 of the relay 1. The contacts 5 may be used to couple or to disconnect load ports 6 of the relay 1. The load ports 6 may be coupled to an AC voltage 700 comprising a sequence of (sinusoidal) cycles at an AC frequency (e.g. 50Hz or 60Hz).

The method 800 comprises applying 801, at a control time instant 331, a control signal to the control port 4 for initiating a switch-off event or a switch-on event of the relay 1. The control time instant 331 typically depends on a previously determined control delay 340 of the relay 1. In particular, the control time instant 331 may occur prior to an upcoming zero crossing time instant 705 of the AC voltage 700, depending on the control delay 340, such that the actual disconnection or connection of the contacts 5 occurs as close as possible to the zero crossing time instant 705 (or to an offset zero crossing time instant 702).

In addition, the method 800 comprises determining 802 a temporal course 201, 202 of the coil current 200 subject to the control signal. In particular, it may be determined how the coil current 200 evolves during the switch-off event or during the switch-on event (until the time instant at which the relay 1 is fully switched-off or fully switched-on).

Furthermore, the method 800 comprises detecting 803 a disconnect time instant 333, at which the contacts 5 of the relay 1 disconnect, or a connect time instant 312, at which the contacts 5 of the relay 1 connect, based on a derivative 321, 302 of the temporal course 201, 202 of the coil current 200. In particular, the disconnect time instant 333 may be determined based on the first derivative 321 of the temporal course 202 of the coil current 200. On the other hand, the connect time instant 312 may be determined based on the second derivative 302 of the temporal course 201 of the coil current 200. In addition, the method 800 may comprise updating 804 the control delay 340 based on the detected disconnect time instant 333 or based on the detected connect time instant 312.

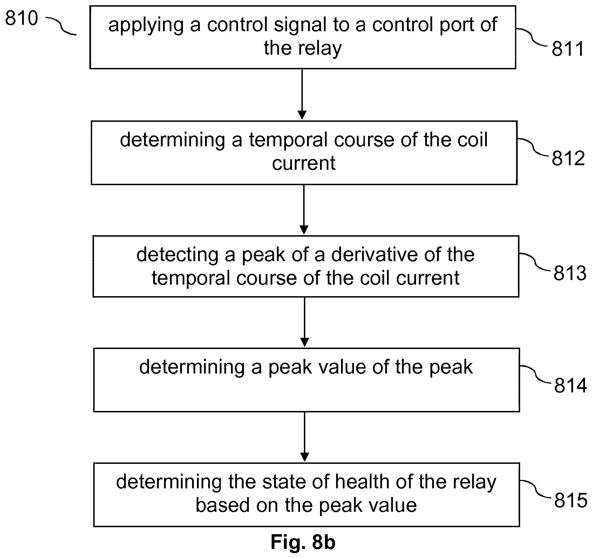

Fig. 8b shows a flow chart of an example method 810 for determining information regarding a state of health of a relay 1. The relay 1 comprises a movable anchor 3 (also referred to herein as an armature) and a coil 2. The coil 8 is configured to exert a force onto the anchor 3 subject to a coil current 200 at a control port 4 of the relay 1, in order to connect contacts 5 of the relay 1.

The method 810 comprises applying 811 a control signal to the control port 4 for initiating a switch-off event or a switch-on event of the relay 1. In particular, a (DC) voltage may be applied to the control port 4, in order to initiate a switch-on event. The (DC) voltage may be disconnected from the control port 4 or the control port 4 may be short circuited, in order to initiate a switch-off event.

In addition, the method 810 comprises determining 812 a temporal course 202 of the coil current 200 subject to the control signal. During a switch-on event, the temporal course 201 may comprise or may be limited to the time interval during which the coil current 200 increases to a substantially constant on-current used for maintaining the relay 1 in the on-state. On the other hand, during a switch-off event, the temporal course 202 may comprise or may be limited to the time interval during which the coil current 200 drops to substantially zero.

Furthermore, the method 810 comprises detecting 813 a peak of a derivative 321, 302 of the temporal course 201, 202 of the coil current 200. In particular, a peak of the first derivative 321 of the temporal course 202 of the coil current 200 during a switch-off event may be detected. The peak may be detected using the circuit 400 described in the present document.

In addition, the method 810 comprises determining 814 a peak value 602 of the peak of the (first) derivative 321, 302 of the temporal course 202 of the coil current 200. The method 810 further comprises determining 815 information regarding the state of health of the relay 1, notably regarding a gap width 601 of a gap S between the contacts 5 of the relay 1, based on the peak value 602. For this purpose, experimental data 600 may be used, which indicates the state of health of the relay 1 as a function of the peak value 602.

The aspects which are outlined in the present document enable a reliable and efficient control of a relay 1. The control scheme allows reducing the deteriorations of a relay 1, which are caused by switch-on or switch-off events of the relay 1. Furthermore, monitoring of the state of health of a relay 1 may be performed, thereby enabling preventive maintenance of the relay 1 and of an appliance (notably a home appliance, such as a dishwasher, a washing machine, an oven, etc). In addition, failures of a relay 1 may be detected.

## Claims

1. A method (800) for controlling a relay (1); wherein the relay (1) comprises a movable anchor (3) and a coil (2) which is configured to exert a force onto the anchor (3) subject to a coil current (200) at a control port (4), in order to connect contacts (5) of the relay (1); wherein the method (800) comprises
- applying (801), at a control time instant (331), a control signal to the control port (4) for initiating a switch-off event or a switch-on event of the relay (1); wherein the control time instant (331) depends on a previously determined control delay (340) of the relay (1);
- determining (802) a temporal course (201, 202) of the coil current (200) subject to the control signal;
- detecting (803) a disconnect time instant (333), at which the contacts (5) of the relay (1) disconnect, or a connect time instant (312), at which the contacts (5) of the relay (1) connect, based on a derivative (321, 302) of the temporal course (201, 202) of the coil current (200); and
- the contacts (5) of the relay (1) are configured to enable or to disable an electrical connection between load ports (6) of the relay (1); **characterised by**
- updating (804) the control delay (340) based on the detected disconnect time instant (333) or based on the detected connect time instant (312), wherein
- an AC voltage (700) is applied to the load ports (6);
- the method (800) comprises, determining a zero crossing time instant (705) of the AC voltage (700), at which the AC voltage (700) changes polarity; and
- the method (800) comprises, determining the control time instant (331) based on the previously determined control delay (340) and based on the zero crossing time instant (705) and wherein
- the method (800) comprises, determining the control time instant (331) as the zero crossing time instant (705) minus the previously determined control delay (340) and minus an offset (703); and
- the offset (703) depends on a degree of reliability, a statistical scatter, of the control delay (340).

2. The method (800) of any previous claim, wherein
- the control signal is for initiating a switch-off event; and
- the disconnect time instant (333) is detected based on the first derivative (321) of the temporal course (202) of the coil current (200).

3. The method (800) of claim 2, wherein the method (800) comprises
- detecting a peak of the first derivative (321) of the temporal course (202) of the coil current (200); and
- detecting (803) the disconnect time instant (333) based on the peak, notably based on a time instant of a maximum of the peak.

4. The method (800) of any of claims 2 to 3, wherein the method (800) comprises
- comparing the first derivative (321) of the temporal course (202) of the coil current (200) with a peak detection threshold (415), in order to determine an envelope (322) of a peak of the first derivative (321) of the temporal course (202) of the coil current (200); and
- detecting (803) the disconnect time instant (333) based on the envelope (322), notably based on a time instant of a center of the envelope (322).

5. The method (800) of any of claims 2 to 4, wherein the method (800) comprises
- determining a peak value (602) of a peak of the first derivative (321) of the temporal course (202) of the coil current (200); and
- determining information regarding a state of health of the relay (1), notably regarding a gap width (601) of a gap between the contacts (5), based on the peak value (602).

6. The method (800) of claim 5, wherein the information regarding the state of health of the relay (1) is determined based on experimental data (600) indicative of the state of health of the relay (1), notably of the gap width (601), as a function of the peak value (602).

7. The method (800) of any of claims 5 to 6, wherein the method (800) comprises initiating that the relay (1) is maintained or replaced, depending on the information regarding the state of health of the relay (1).

8. The method (800) of claim 1, wherein
- the control signal is for initiating a switch-on event; and
- the connect time instant (312) is detected based on the second derivative (302) of the temporal course (201) of the coil current (200), notably based on a minimum of the second derivative (302) of the temporal course (201) of the coil current (200).

9. A control unit (100, 400) for controlling a relay (1); wherein the relay (1) comprises a movable anchor (3) and a coil (2) which is configured to exert a force onto the anchor (3) subject to a coil current (200) at a control port (4), in order to connect contacts (5) of the relay (1); wherein the control unit (100, 400) is configured to
- apply, at a control time instant (331), a control signal to the control port (4) for initiating a switch-off event or a switch-on event of the relay (1); wherein the control time instant (331) depends on a previously determined control delay (340) of the relay (1);
- determine a temporal course (201, 202) of the coil current (200) subject to the control signal;
- detect a disconnect time instant (333), at which the contacts (5) of the relay (1) disconnect, or a connect time instant (312), at which the contacts (5) of the relay (1) connect, based on a derivative (321, 302) of the temporal course (201, 202) of the coil current (200); and
- the contacts (5) of the relay (1) are configured to enable or to disable an electrical connection between load ports (6) of the relay (1); **characterised in that** the control unit is further configured to
- update the control delay (340) based on the detected disconnect time instant (333) or based on the detected connect time instant (312), and wherein
- an AC voltage (700) is applied to the load ports (6);
- the control unit (100, 400) is configured for determining a zero crossing time instant (705) of the AC voltage (700), at which the AC voltage (700) changes polarity; and
- for determining the control time instant (331) based on the previously determined control delay (340) and based on the zero crossing time instant (705) and wherein
- the control unit (100, 400) is further configured for determining the control time instant (331) as the zero crossing time instant (705) minus the previously determined control delay (340) and minus an offset (703); whereby
- the offset (703) depends on a degree of reliability, a statistical scatter, of the control delay (340).

10. The control unit (100, 400) of claim 9, wherein the control unit (100, 400) comprises
- a conversion resistor (R10) configured to convert the coil current (200) into a coil voltage (410);
- derivation circuitry (401, 402, 403) configured to determine a first output signal (413) indicative of a derivative of the course of the coil voltage (410), based on the course of the coil voltage (410); and
- a microprocessor configured to sense the first output signal (413) or a signal (416) derived therefrom; wherein the microprocessor is configured to detect the disconnect time instant (333) or the connect time instant (312) based on the sensed first output signal (413) or the signal (416) derived therefrom, and to update the control delay (340).

11. The control unit (100, 400) of claim 10, wherein
- the control unit (100, 400) is configured to control a plurality of relays (1);
- the derivation circuitry (401, 402, 403) comprises an input portion (C1) and an output portion (R3, 401, 403);
- the control unit (100, 400) comprises a plurality of conversion resistors (R10) for the corresponding plurality of relays (1);
- the control unit (100, 400) comprises a plurality of input portions (C1) for the corresponding plurality of relays (1), and a single output portion (R3, 401, 403) for the plurality of relays (1); and
- the control unit (100, 400) is configured to detect the disconnect time instant (333) or the connect time instant (312) of the plurality of relays (1) at a corresponding plurality of sequential time intervals, notably at a corresponding plurality of half cycles of an AC voltage (700) applied to load ports (6) of the plurality of relays (1).

12. The control unit (100, 400) of any of claims 10 to 11, wherein
- the control unit (100, 400) comprises a comparator (401) configured to compare the first output signal (413) with a peak detection threshold (415) to determine a second output signal (416) which is indicative of a rectangular envelope (322) around a peak of the first output signal (413); and
- the microprocessor is configured to detect the disconnect time instant (333) or the connect time instant (312) based on the second output signal (416).

## Patentansprüche

1. Verfahren (800) zum Steuern eines Relais (1), wobei das Relais (1) einen beweglichen Anker (3) und eine Spule (2) umfasst, die so konfiguriert ist, dass sie in Abhängigkeit von einem Spulenstrom (200) an einem Steueranschluss (4) zum Verbinden von Kontakten (5) des Relais (1) eine Kraft auf den Anker (3) ausübt, wobei das Verfahren (800) Folgendes umfasst:
- zu einem Steuerzeitpunkt (331) Anlegen (801) eines Steuersignals an dem Steueranschluss (4) zum Veranlassen eines Aus- oder Einschaltens des Relais (1), wobei der Steuerzeitpunkt (331) von einer zuvor bestimmten Steuerverzögerung (340) des Relais (1) abhängig ist,
- Bestimmen (802) eines Zeitverlaufs (201, 202) des Spulenstroms (200) in Abhängigkeit von dem Steuersignal,
- Erkennen (803) eines Öffnungszeitpunkts (333), zu dem sich die Kontakte (5) des Relais (1) öffnen, oder eines Schließzeitpunkts (312), zu dem sich die Kontakte (5) des Relais (1) schließen, auf der Grundlage einer Ableitung (321, 302) des Zeitverlaufs (201, 202) des Spulenstroms (200) und
- wobei die Kontakte (5) des Relais (1) so konfiguriert sind, dass sie eine elektrische Verbindung zwischen Lastanschlüssen (6) des Relais (1) herstellen oder trennen, **gekennzeichnet durch**:
- Aktualisieren (804) der Steuerverzögerung (340) auf der Grundlage des erkannten Öffnungszeitpunkts (333) oder des erkannten Schließzeitpunkts (312), wobei
- eine Wechselspannung (700) an die Lastanschlüsse (6) angelegt wird,
- das Verfahren (800) das Bestimmen eines Nulldurchgangszeitpunkts (705) der Wechselspannung (700) umfasst, zu dem sich die Polarität der Wechselspannung (700) ändert, und
- das Verfahren (800) das Bestimmen des Steuerzeitpunkts (331) auf der Grundlage der zuvor bestimmten Steuerverzögerung (340) und des Nulldurchgangszeitpunkts (705) umfasst und wobei
- das Verfahren (800) das Bestimmen des Steuerzeitpunkts (331) als Nulldurchgangszeitpunkt (705) minus der zuvor bestimmten Steuerverzögerung (340) und minus einen Versatz (703) umfasst und
- der Versatz (703) von einem Verlässlichkeitsgrad, einer statistischen Streuung, der Steuerverzögerung (340) abhängig ist.

2. Verfahren (800) nach einem der vorhergehenden Ansprüche, wobei:
- das Steuersignal zum Veranlassen eines Ausschaltens dient und
- der Öffnungszeitpunkt (333) auf der Grundlage der ersten Ableitung (321) des Zeitverlaufs (202) des Spulenstroms (200) erkannt wird.

3. Verfahren (800) nach Anspruch 2, wobei das Verfahren (800) Folgendes umfasst:
- Erkennen einer Spitze der ersten Ableitung (321) des Zeitverlaufs (202) des Spulenstroms (200) und
- Erkennen (803) des Öffnungszeitpunkts (333) auf der Grundlage der Spitze, insbesondere auf der Grundlage eines Zeitpunkts eines Maximums der Spitze.

4. Verfahren (800) nach einem der Ansprüche 2 bis 3, wobei das Verfahren (800) Folgendes umfasst:
- Vergleichen der ersten Ableitung (321) des Zeitverlaufs (202) des Spulenstroms (200) mit einer Spitzenerkennungsschwelle (415) zwecks Bestimmens einer Hüllkurve (322) für eine Spitze der ersten Ableitung (321) des Zeitverlaufs (202) des Spulenstroms (200) und
- Erkennen (803) des Öffnungszeitpunkts (333) auf der Grundlage der Hüllkurve (322), insbesondere auf der Grundlage eines Zeitpunkts eines Mittelpunkts der Hüllkurve (322).

5. Verfahren (800) nach einem der Ansprüche 2 bis 4, wobei das Verfahren (800) Folgendes umfasst:
- Bestimmen eines Spitzenwerts (602) einer Spitze der ersten Ableitung (321) des Zeitverlaufs (202) des Spulenstroms (200) und
- Bestimmen von Informationen bezüglich eines Zustands des Relais (1), insbesondere bezüglich einer Spaltbreite (601) eines Spalts zwischen den Kontakten (5), auf der Grundlage des Spitzenwerts (602).

6. Verfahren (800) nach Anspruch 5, wobei die Informationen bezüglich des Zustands des Relais (1) auf der Grundlage von experimentellen Daten (600) bestimmt werden, die den Zustand des Relais (1), insbesondere die Spaltbreite (601), in Abhängigkeit von dem Spitzenwert (602) anzeigen.

7. Verfahren (800) nach einem der Ansprüche 5 bis 6, wobei das Verfahren (800) das Veranlassen umfasst, dass das Relais (1) in Abhängigkeit von den Informationen bezüglich seines Zustands gewartet oder ausgetauscht wird.

8. Verfahren (800) nach Anspruch 1, wobei:
- das Steuersignal zum Veranlassen eines Einschaltens dient und
- auf der Grundlage der zweiten Ableitung (302) des Zeitverlaufs (201) des Spulenstroms (200), insbesondere auf der Grundlage eines Minimums der zweiten Ableitung (302) des Zeitverlaufs (201) des Spulenstroms (200), der Schließzeitpunkt (312) erkannt wird.

9. Steuereinheit (100, 400) zum Steuern eines Relais (1), wobei das Relais (1) einen beweglichen Anker (3) und eine Spule (2) umfasst, die so konfiguriert ist, dass sie in Abhängigkeit von einem Spulenstrom (200) an einem Steueranschluss (4) zum Verbinden von Kontakten (5) des Relais (1) eine Kraft auf den Anker (3) ausübt, wobei die Steuereinheit (100, 400) so konfiguriert ist, dass sie:
- zu einem Steuerzeitpunkt (331) zum Veranlassen eines Aus- oder Einschaltens des Relais (1) ein Steuersignal an dem Steueranschluss (4) anlegt, wobei der Steuerzeitpunkt (331) von einer zuvor bestimmten Steuerverzögerung (340) des Relais (1) abhängig ist,
- in Abhängigkeit von dem Steuersignal einen Zeitverlauf (201, 202) des Spulenstroms (200) bestimmt,
- auf der Grundlage einer Ableitung (321, 302) des Zeitverlaufs (201, 202) des Spulenstroms (200) einen Öffnungszeitpunkt (333), zu dem sich die Kontakte (5) des Relais (1) öffnen, oder einen Schließzeitpunkt (312) erkennt, zu dem sich die Kontakte (5) des Relais (1) schließen, und
- wobei die Kontakte (5) des Relais (1) so konfiguriert sind, dass sie eine elektrische Verbindung zwischen Lastanschlüssen (6) des Relais (1) herstellen oder trennen, **dadurch gekennzeichnet, dass** die Steuereinheit ferner so konfiguriert ist, dass sie:
- die Steuerverzögerung (340) auf der Grundlage des erkannten Öffnungszeitpunkts (333) oder des erkannten Schließzeitpunkts (312) aktualisiert, und wobei
- eine Wechselspannung (700) an die Lastanschlüsse (6) angelegt wird,
- die Steuereinheit (100, 400) zum Bestimmen eines Nulldurchgangszeitpunkts (705) der Wechselspannung (700) konfiguriert ist, zu dem sich die Polarität der Wechselspannung (700) ändert, und
- zum Bestimmen des Steuerzeitpunkts (331) auf der Grundlage der zuvor bestimmten Steuerverzögerung (340) und des Nulldurchgangszeitpunkts (705) und wobei
- die Steuereinheit (100, 400) ferner zum Bestimmen des Steuerzeitpunkts (331) als Nulldurchgangszeitpunkt (705) minus der zuvor bestimmten Steuerverzögerung (340) und minus einen Versatz (703) konfiguriert ist, wodurch
- der Versatz (703) von einem Verlässlichkeitsgrad, einer statistischen Streuung, der Steuerverzögerung (340) abhängig ist.

10. Steuereinheit (100, 400) nach Anspruch 9, wobei die Steuereinheit (100, 400) Folgendes umfasst:
- einen Umwandlungswiderstand (R10), der so konfiguriert ist, dass er den Spulenstrom (200) in eine Spulenspannung (410) umwandelt,
- Ableitungsschaltungen (401, 402, 403), die so konfiguriert sind, dass sie auf der Grundlage des Verlaufs der Spulenspannung (410) ein erstes Ausgangssignal (413) bestimmen, das eine Ableitung des Verlaufs der Spulenspannung (410) anzeigt, und
- einen Mikroprozessor, der so konfiguriert ist, dass er das erste Ausgangssignal (413) oder ein davon abgeleitetes Signal (416) erfasst, wobei der Mikroprozessor so konfiguriert ist, dass er den Öffnungszeitpunkt (333) oder den Schließzeitpunkt (312) auf der Grundlage des erfassten ersten Ausgangssignals (413) oder des davon abgeleiteten Signals (416) erkennt und die Steuerverzögerung (340) aktualisiert.

11. Steuereinheit (100, 400) nach Anspruch 10, wobei:
- die Steuereinheit (100, 400) so konfiguriert ist, dass sie mehrere Relais (1) steuert,
- die Ableitungsschaltungen (401, 402, 403) einen Eingangsabschnitt (C1) und einen Ausgangsabschnitt (R3, 401, 403) umfassen,
- die Steuereinheit (100, 400) mehrere Umwandlungswiderstände (R10) für die mehreren entsprechenden Relais (1) umfasst,
- die Steuereinheit (100, 400) mehrere Eingangsabschnitte (C1) für die mehreren entsprechenden Relais (1) und einen einzigen Ausgangsabschnitt (R3, 401, 403) für die mehreren Relais (1) umfasst und
- die Steuereinheit (100, 400) so konfiguriert ist, dass sie den Öffnungszeitpunkt (333) oder den Schließzeitpunkt (312) der mehreren Relais (1) in mehreren entsprechenden aufeinanderfolgenden Zeitabständen, insbesondere in mehreren entsprechenden Halbzyklen einer Wechselspannung (700) erkennt, die an Lastanschlüsse (6) der mehreren Relais (1) angelegt ist.

12. Steuereinheit (100, 400) nach einem der Ansprüche 10 bis 11, wobei:
- die Steuereinheit (100, 400) einen Vergleicher (401) umfasst, der so konfiguriert ist, dass er das erste Ausgangssignal (413) mit einer Spitzenerkennungsschwelle (415) vergleicht und so ein zweites Ausgangssignal (416) bestimmt, das eine rechteckige Hüllkurve (322) um eine Spitze des ersten Ausgangssignals (413) herum anzeigt, und
- der Mikroprozessor so konfiguriert ist, dass er auf der Grundlage des zweiten Ausgangssignals (416) den Öffnungszeitpunkt (333) oder den Schließzeitpunkt (312) erkennt.

## Revendications

1. Procédé (800) de commande d'un relais (1) ; dans lequel le relais (1) comprend un ressort de tension (3) mobile et une bobine (2) laquelle est réalisée pour exercer une force sur le ressort de tension (3) soumis à un courant de bobine (200) à une borne de commande (4) afin de connecter les contacts (5) du relais (1) ; dans lequel le procédé (800) comprend
- l'application (801), à un instant de temps de commande (331), d'un signal de commande à la borne de commande (4) pour initier un événement de mise hors tension ou un événement de mise sous tension du relais (1) ; dans lequel l'instant de temps de commande (331) dépend d'une temporisation de commande (340) précédemment déterminée du relais (1) ;
- la détermination (802) d'une course temporelle (201, 202) du courant de bobine (200) soumis au signal de commande ;
- la détection (803) d'un instant de temps de déconnexion (333) auquel les contacts (5) du relais (1) se déconnectent, ou un instant de temps de connexion (312) auquel les contacts (5) du relais (1) se connectent, sur base d'une dérivée (321, 302) de la course temporelle (201, 202) du courant de bobine (200) ; et
- les contacts (5) du relais (1) sont réalisés pour activer ou désactiver une connexion électrique entre les bornes de charge (6) du relais (1) ; **caractérisé par**
- la mise à jour (804) de la temporisation de commande (340) sur base de l'instant de temps de déconnexion (333) détecté ou sur base de l'instant de temps de connexion (312) détecté, dans lequel
- une tension de courant alternatif (700) est appliquée aux bornes de charge (6) ;
- le procédé (800) comprend la détermination d'un instant de temps de croisement zéro (705) de la tension de courant alternatif (700) auquel la tension de courant alternatif (700) inverse sa polarité ; et
- le procédé (800) comprend la détermination de l'instant de temps de commande (331) sur base de la temporisation de commande (340) précédemment déterminée et sur base de l'instant de temps de croisement zéro (705) et dans lequel
- le procédé (800) comprend la détermination de l'instant de temps de commande (331) en tant qu'instant de temps de croisement zéro (705) moins la temporisation de commande (340) précédemment déterminée et moins un décalage (703) ; et
- le décalage (703) dépend d'un degré de fiabilité, une diffusion statistique, de la temporisation de commande (340).

2. Procédé (800) selon l'une quelconque revendication précédente, dans lequel
- le signal de commande sert à initier un événement de mise hors tension ; et
- l'instant de temps de déconnexion (333) est détecté sur base de la première dérivée (321) de la course temporelle (202) du courant de bobine (200).

3. Procédé (800) selon la revendication 2, dans lequel le procédé (800) comprend
- la détection d'un pic de la première dérivée (321) de la course temporelle (202) du courant de bobine (200) ; et
- la détection (803) de l'instant de temps de déconnexion (333) sur base du pic, notamment sur base de l'instant de temps d'un plus haut point du pic.

4. Procédé (800) selon l'une quelconque des revendications 2 à 3, dans lequel le procédé (800) comprend
- la comparaison de la première dérivée (321) de la course temporelle (202) du courant de bobine (200) avec un seuil de détection de pic (415) afin de déterminer une enveloppe (322) d'un pic de la première dérivée (321) de la course temporelle (202) du courant de bobine (200) ; et
- la détection (803) de l'instant de temps de déconnexion (333) sur base de l'enveloppe (322), notamment sur base d'un instant de temps du centre de l'enveloppe (322).

5. Procédé (800) selon l'une quelconque des revendications 2 à 4, dans lequel le procédé (800) comprend
- la détermination d'une valeur de pic (602) d'un pic de la première dérivée (321) de la course temporelle (202) du courant de bobine (200) ; et
- la détermination d'informations relatives au bon état du relais (1), concernant notamment la largeur d'interstice (601) d'un interstice entre les contacts (5), sur base de la valeur de pic (602).

6. Procédé (800) selon la revendication 5, dans lequel les informations relatives au bon état du relais (1) sont déterminées sur base de données expérimentales (600) indiquant le bon état du relais (1), notamment la largeur d'interstice (601), en fonction de la valeur de pic (602).

7. Procédé (800) selon l'une quelconque des revendications 5 à 6, dans lequel le procédé (800) comprend l'initiation faisant que le relais (1) sera maintenu ou remplacé, en fonction des informations relatives au bon état du relais (1).

8. Procédé (800) selon la revendication 1, dans lequel
- le signal de commande sert à initier un événement de mise sous tension ; et
- l'instant de temps de connexion (312) est détecté sur base de la deuxième dérivée (302) de la course temporelle (201) du courant de bobine (200), notamment sur base d'un point le plus bas de la deuxième dérivée (302) de la course temporelle (201) du courant de bobine (200).

9. Unité de commande (100, 400) destinée à commander un relais (1) ; dans laquelle le relais (1) comprend un ressort de tension (3) mobile et une bobine (2) laquelle est réalisée pour exercer une force sur le ressort de tension (3) soumis à un courant de bobine (200) à une borne de commande (4) afin de connecter les contacts (5) du relais (1) ; dans laquelle l'unité de commande (100, 400) est réalisée pour
- appliquer, à un instant de temps de commande (331), un signal de commande à la borne de commande (4) pour initier un événement de mise hors tension ou un événement de mise sous tension du relais (1) ; dans laquelle l'instant de temps de commande (331) dépend d'une temporisation de commande précédemment déterminée (340) du relais (1) ;
- déterminer une course temporelle (201, 202) du courant de bobine (200) soumis au signal de commande ;
- détecter un instant de temps de déconnexion (333) auquel les contacts (5) du relais (1) se déconnectent, ou un instant de temps de connexion (312) auquel les contacts (5) du relais (1) se connectent, sur base d'une dérivée (321, 302) de la course temporelle (201, 202) du courant de bobine (200) ; et
- les contacts (5) du relais (1) sont réalisés pour activer ou désactiver une connexion électrique entre les bornes de charge (6) du relais (1) ;
**caractérisée en ce que** l'unité de commande est de plus réalisée pour
- mettre à jour la temporisation de commande (340) sur base de l'instant de temps de déconnexion (333) détecté ou sur base de l'instant de temps de connexion (312) détecté, et dans laquelle
- une tension de courant alternatif (700) est appliquée aux bornes de charge (6) ;
- l'unité de commande (100, 400) est réalisée pour déterminer un instant de temps de croisement zéro (705) de la tension de courant alternatif (700), auquel la tension de courant alternatif (700) inverse sa polarité ; et
- pour déterminer l'instant de temps de commande (331) sur base de la temporisation de commande précédemment déterminée (340) et sur base de l'instant de temps de croisement zéro (705) et dans laquelle
- l'unité de commande (100, 400) est de plus réalisée pour déterminer l'instant de temps de commande (331) en tant qu'instant de temps de croisement zéro (705) moins la temporisation de commande précédemment déterminée (340) et moins un décalage (703) ; ce qui fait que
- le décalage (703) dépend d'un degré de fiabilité, une diffusion statistique, de la temporisation de commande (340).

10. Unité de commande (100, 400) selon la revendication 9, dans laquelle l'unité de commande (100, 400) comprend
- une résistance de conversion (R10) réalisée pour convertir le courant de bobine (200) en une tension de bobine (410) ;
- des circuits de dérivation (401, 402, 403) réalisés pour déterminer un premier signal de sortie (413) indiquant une dérivée de la course de la tension de bobine (410) sur base de la course de la tension de bobine (410) ; et
- un microprocesseur réalisé pour capter le premier signal de sortie (413) ou un signal (416) dérivé de celui-ci ; dans laquelle le microprocesseur est réalisé pour détecter l'instant de temps de déconnexion (333) ou l'instant de temps de connexion (312) sur base du premier signal de sortie capté (413) ou du signal (416) dérivé de celui-ci, et mettre à jour la temporisation de commande (340).

11. Unité de commande (100, 400) selon la revendication 10, dans laquelle
- l'unité de commande (100, 400) est réalisée pour commander une pluralité de relais (1) ;
- les circuits de dérivation (401, 402, 403) comprennent une partie d'entrée (C1) et une partie de sortie (R3, 401, 403) ;
- l'unité de commande (100, 400) comprend une pluralité de résistances de conversion (R10) pour la pluralité correspondante de relais (1) ;
- l'unité de commande (100, 400) comprend une pluralité de parties d'entrée (C1) pour la pluralité correspondante de relais (1), et une seule partie de sortie (R3, 401, 403) pour la pluralité de relais (1) ; et
- l'unité de commande (100, 400) est réalisée pour détecter l'instant de temps de déconnexion (333) ou l'instant de temps de connexion (312) de la pluralité de relais (1) à une pluralité correspondante d'intervalles de temps séquentiels, notamment à une pluralité correspondante de demi-cycles d'une tension de courant alternatif (700) appliquée aux bornes de charge (6) de la pluralité de relais (1).

12. Unité de commande (100, 400) selon l'une quelconque des revendications 10 à 11, dans laquelle
- l'unité de commande (100, 400) comprend un comparateur (401) réalisé pour comparer le premier signal de sortie (413) avec un seuil de détection de pic (415) pour déterminer un deuxième signal de sortie (416) indiquant une enveloppe rectangulaire (322) autour d'un pic du premier signal de sortie (413) ; et
- le microprocesseur est réalisé pour détecter l'instant de temps de déconnexion (333) ou l'instant de temps de connexion (312) sur base du deuxième signal de sortie (416).
